# EUROPEAN PATENT SPECIFICATION

(11) **EP 1 026 692 B1**
(45) Date of publication and mention of the grant of the patent: **26.02.2003**
(21) Application number: 00106193.6
(22) Date of filing: 01.10.1993
(51) Int. Cl.: G11C 7/00, G11C 11/407, G11C 7/10

(54) **Data output buffers in semiconductor memory devices**
Datenausgangspuffer in Halbleiterspeicheranordnungen
Tampons de sortie de données dans des dispositifs de mémoire à semi-conducteurs

(30) Priority: 02.10.1992 KR 9218133
(43) Date of publication of application: 09.08.2000
(62) Divisional of application: 93307860.2
(73) Proprietor: Samsung Electronics Co., Ltd., Suwon City, Kyungki-do 442-370 (KR)
(72) Inventor: Lee, Ho-Cheol, Seoul (KR)
(74) Representative: Eisenführ, Speiser & Partner

(56) References cited:
- EP-A- 0 481 437
- EP-A- 0 487 288

## Description

This invention relates to semiconductor memory devices, and more particularly to data output buffers therefor.

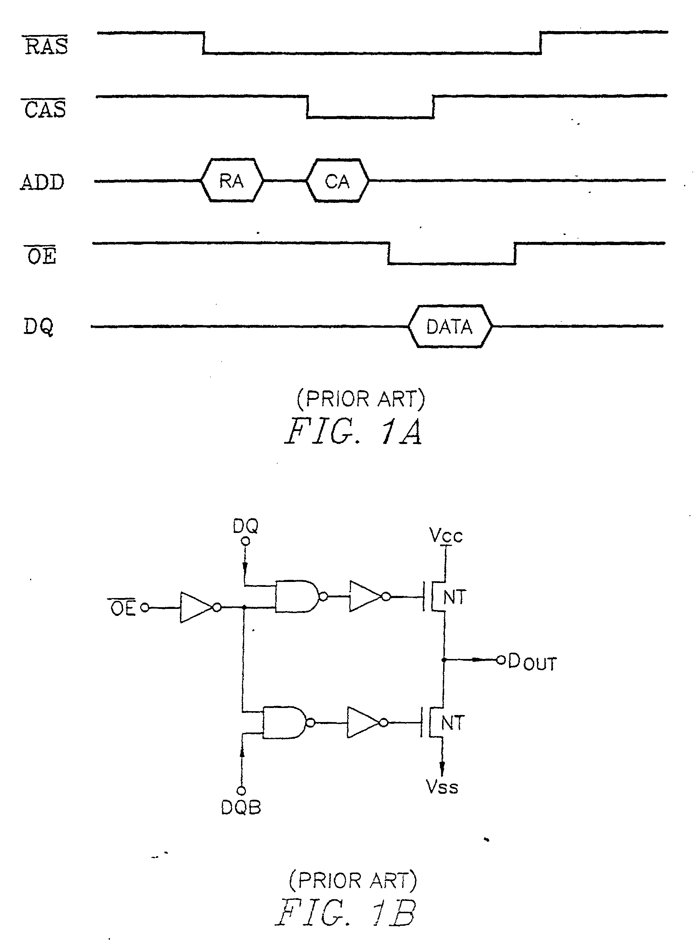

A dynamic RAM, a typical readable/writable memory, is essentially provided with a row address strobe (hereinafter referred to as "RAS") signal and a column address strobe (hereinafter referred to as "CAS") signal, respectively supplied from an external circuit such as a CPU, so as to read or write data from/into a memory cell therein. Referring to Figure 1A of the accompanying diagrammatic drawings for showing a timing diagram for a read cycle in a conventional dynamic RAM, a row address signal RA is input to the memory device after a /RAS signal (indicative of an inverse RAS signal) has been enabled to "low" state and then, a column address signal CA is input after a /CAS signal (indicative of an inverse CAS signal) has been enabled to "low" state while the /RAS signal holds at the active cycle. As a result, data stored in a memory cell corresponding to the address signal inputs is sensed by a sense amplifier. The data sensed is output through a data output buffer. When this takes place, data paths of the data output buffer are connected or disconnected according to an output enable signal /OE (see Figure 1B of the accompanying diagrammatic drawings). It is well known that the output enable signal /OE is generated by using a control clock supplied from the CPU and a signal generated in the memory chip for data sensing.

In a conventional dynamic RAM, during one /CAS cycle, only one bit of the output data is output in the case of a page mode and four bits of the output data are output in the case of a nibble mode. The data output operation is inhibited once the /RAS signal has been disabled as it -enters into a precharge cycle. In practice, however, at every read cycle, a time interval t_{RAC} covering from an enabling point of the /RAS signal to a point at which the output data is substantially generated responding to the /RAS signal, is essentially required.- A data input/output line is equalized and precharged during a time interval from when data is output from the chip at a /RAS cycle to when next data is output again from the chip at the next /RAS cycle. Thus, it becomes apparent that the above mentioned time interval t_{RAC} is much longer than a time required for equalizing and precharging the data input/output line. That is, a time loss is unnecessarily caused between a current data output cycle and a subsequent data output cycle.

Also, a conventional dynamic RAM carries out a data access operation according to various control signals asynchronously. Furthermore, a data bus and an input/output bus are equalized and precharged for various time intervals between a current and a subsequent read cycle, between read and write cycles, and between a current and a subsequent write cycle. Moreover, a memory device formed on an integrated circuit receives TTL level signals provided from a CPU and converts them to CMOS level signals before using them. As widely known, up until now, the operation speed of a CPU has been improved far more than that of memory devices. Therefore, a need to make the operation of a memory device faster, in order to shorten data access time, is increasingly felt among manufacturers.

The European patent application EP 0 487 288 is directed towards a synchronous dynamic random-access memory which comprises latch circuits that latch address signals in synchronization with a clock signal. An output buffer is foreseen for outputting data which are stored in the memory device after an address strobe signal has become activated. An output buffer control signal is synchronized with a clock signal.

The US patent 4,602,353 is concerned with an integrated semiconductor circuit with a dynamic read-write memory. According to the teaching disclosed in this document the control of the data output via the column address strobe CAS bar is constructed in such a manner that the information present at the data output is preserved at the data output of the memory after decay of the column address strobe signal CAS bar causing its readout for a defined time span to last until the next column address strip signal CAS bar is set in.

However, the operation speed of the conventional asynchronous dynamic RAM can be increased only to a certain extent and no more due to its unique operation structure. To solve this problem, it is needed to develop a memory device that is capable of carrying out a data read/write operation in synchronism with an external clock supplied from a CPU.

Preferred embodiments of the present invention aim to provide a data output buffer capable of carrying out an effective data output operation, used for a memory device operating in synchronism with a clock supplied from an external source.

It is another aim to provide a semiconductor memory device having a data output buffer controlling device capable of outputting data even during a /RAS precharge cycle.

It is also another aim to provide a semiconductor memory device having a device for controlling a data output buffer in synchronism with a clock supplied from an external source.

The invention is defined by claims 1 and 2.

According to one aspect of the present invention, there is provided a semiconductor memory device including a data output buffer receiving a clock, the device comprising:
means for generating a control signal for controlling said data output buffer according to an address strobe signal and a predetermined combination signal in response to said clock.

Said address strobe signal may comprise a row address strobe signal, a column address strobe signal, or both.

Preferably, said clock is supplied from an external source.

Preferably, said combination signal is an address combination signal.

According to another aspect of the present invention, there is provided a semiconductor memory device including a data output buffer receiving an address strobe signal and a clock, the device comprising;
shifting means including a plurality of clock stages for transmitting said address strobe signal in response to said clock having a predefined cycle;
means for extracting a data output margin signal from a predetermined clock stage among said clock stages; and
means receiving said data output margin signal, for generating a data output buffer control signal in dependence upon the outputs of said clock stages and address signal inputs to provide said data output buffer with said data output buffer control signal.

Preferably, said clock is supplied from an external source of the semiconductor memory device.

According to a further aspect of the present invention, there is provided a semiconductor memory device having a data output buffer, receiving a row address strobe signal and a column address strobe signal, the device comprising;
first shifting means having a plurality of clock stages for transmitting said row address strobe signal in response to a clock having a predefined cycle;
means for extracting a data output margin signal from a predetermined stage among the stages of said first shifting means;
first combining means receiving said data output margin signal, for generating a plurality of first latency signals having information on said row address strobe signal by combining row address signals and the signals extracted from the respective clock stages of said first shifting means;
second shifting means having a plurality of clock stages for transmitting said column address strobe signal in response to said clock;
second combining means receiving said data output margin signal, for generating a plurality of second latency signals having information on said column address strobe signal by combining column address signals and the signals extracted from the respective clock stages of said second shifting means; and
third combining means receiving said first and second latency signals, for generating a data output control signal to said data output buffer.

Preferably, said clock is supplied from an external source of the semiconductor memory device.

According to another aspect of the present invention, a semiconductor memory device includes a first shift register having a plurality of clock stages for transmitting a /RAS signal in response to the clock; a circuit for extracting a data output margin signal from a predetermined stage among the stages of the first shift circuit; first latch circuits each receiving the data output margin signal, for generating a plurality of first latency signals having information on the /RAS signal by combining row address signals and the signals extracted from the respective clock stages of the first shift circuit; a second shift circuit having a plurality of clock stages for transmitting a /CAS signal in response to the clock; second latch circuits each receiving the data output margin signal, for generating a plurality of second latency signals having information on the /CAS signal by combining column address signals and the signals extracted from the respective clock stages of the second shift circuit; and a latency combination circuit receiving the first and second latency signals, for generating a data output control signal to the data output buffer, so that the data output buffer can generate data output even during a /RAS precharge cycle.

For a better understanding of the invention, and to show how the same may be carried into effect, reference will now be made, by way of example, to Figures 2 to 6 of the accompanying diagrammatic drawings, in which:
Figure 2 shows a pin configuration of a dynamic RAM using an external system clock, to which embodiments of the present invention may be applied;
Figure 3 is a schematic diagram of a data output buffer and a control circuit therefor according to one embodiment of the present invention;
Figure 4A is a detailed circuit diagram of a /RAS signal processor 100 shown in Figure 3;
Figure 4B is a detailed circuit diagram of a /CAS signal processor 200 shown in Figure 3;
Figure 4C is a timing diagram showing an example of a read operation according to Figure 3;
Figure 4D is a timing diagram showing another example of a read operation according to Figure 3;
Figure 5 is a schematic diagram of a data output buffer and a control circuit therefor according to another embodiment of the present invention;
Figure 6A is a detailed circuit diagram of a /RAS signal processor 100' shown in Figure 5;
Figure 6B is a detailed circuit diagram of a /CAS signal processor 200' shown in Figure 5;
Figure 6C is a timing diagram showing one example of a read operation according to Figure 5; and
Figure 6D is a timing diagram showing another example of a read operation according to Figure 5.

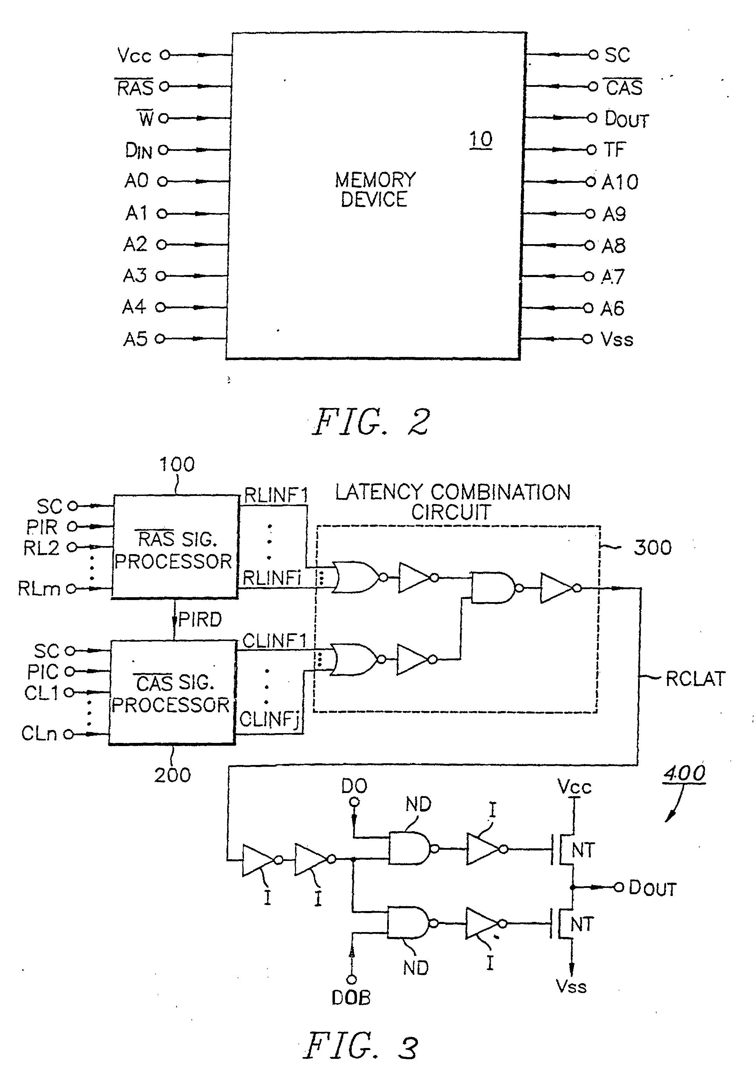

An example of a data output buffer according to the present invention is applied to a memory device 10 that processes all signals in response to a clock (hereinafter referred to as "system clock") supplied from an external source, as shown in Figure 2, which illustrates a basic pin configuration of a synchronous dynamic RAM operating in synchronism with the system clock SC. In the drawing, Vcc indicates a power supply pin, /W a write control signal input pin, D_{IN} a data input pin, A0-A10 address input pins, D_{OUT} a data output pin, TF a test pin, Vss a ground voltage pin, /RAS a row address strobe signal input pin, and /CAS a column address strobe signal input pin, respectively. Moreover, a pin SC for receiving a system clock from a CPU (not shown) is illustrated. In this disclosure, various embodiments of the present invention will be applied to a dynamic RAM, for the simplicity of explaining the inventive concept. It should be noted, however, that other memory devices such as a static RAM can be used for the same purpose. Further, it should be noted that in the following description of the embodiments of the present invention, data stored in a memory cell is accessed in synchronism with the system clock as a reference clock.

Figure 3 shows a generation of a latency signal RCLAT for controlling a data output buffer 400 and how the data output buffer 400 operates using the latency signal RCLAT. In the drawing, a /RAS signal processor 100 receives a system clock SC, a /RAS master clock PIR, and row address combination signals RL1-RLm and outputs /RAS latency signals RLINF1 to RLINFi, and a data output margin signal PIRD used to ensure the outputting of data even during a /RAS precharge cycle. The /RAS master clock PIR is a signal generated in synchronism with the system clock SC triggered up after the /RAS signal had entered into an active cycle or had been enabled. Here, the term "/RAS latency" refers to a time interval covering from an enabling point of the /RAS signal to a point at which an output is generated responding to the /RAS signal. On the other hand, a /CAS signal processor 200 receives the system clock SC. a /CAS master clock PIC, the column address combination signals CL1-CLn, and the data output margin signal PIRD generated from the /RAS signal processor 100, and generates a /CAS latency signals CLINF1 to CLINFj. The /CAS master clock PIC, as in the case of the signal PIR, is a signal generated in synchronism with the system clock SC triggered up after a /CAS signal had entered into an active cycle or had been enabled. The term "CAS latency" refers to a time interval covering from an enabling point of the /CAS signal to a point at which an output is generated responding to the /CAS signal.

The /RAS latency signals RLINF1-RNLINFi and /CAS latency signals CLINF1-CLINFj, respectively generated from the /RAS signal processor 100 and the /CAS signal processor 200 are input into a latency combination circuit 300 comprised of logic gates such as NOR gates, a NAND gate, and inverters. The latency combination circuit 300, by using the /RAS latency signals RLINF1-RLINFi and the /CAS latency signals CLINF1-CLINFj, generates the latency signal RCLAT into which the information of the /RAS latency signals and the /CAS latency signals is included and then, inputs the latency signal RCLAT to the data output buffer 400. It can be understood that the latency signal RCLAT controls data transmission paths of the data output buffer 400 and a time interval thereof at which the data is output. The latency signal RCLAT serves as the output enable signal /OE in the conventional data output buffer shown in Figure 1B. It should be noted that the latency signal RCLAT can be generated from both the /RAS signal and the /CAS signal, or any one of those signals. When using only the /RAS signal according to an embodiment of the present invention of Figure 3, for example, the latency signal RCLAT can be generated by changing one of /RAS latency signals RLINF1-RLINFj to an active state using the /RAS signal processor 100 only and removing the /CAS signal processor 200, and then inputting the activated signal into the latency combination circuit 300.

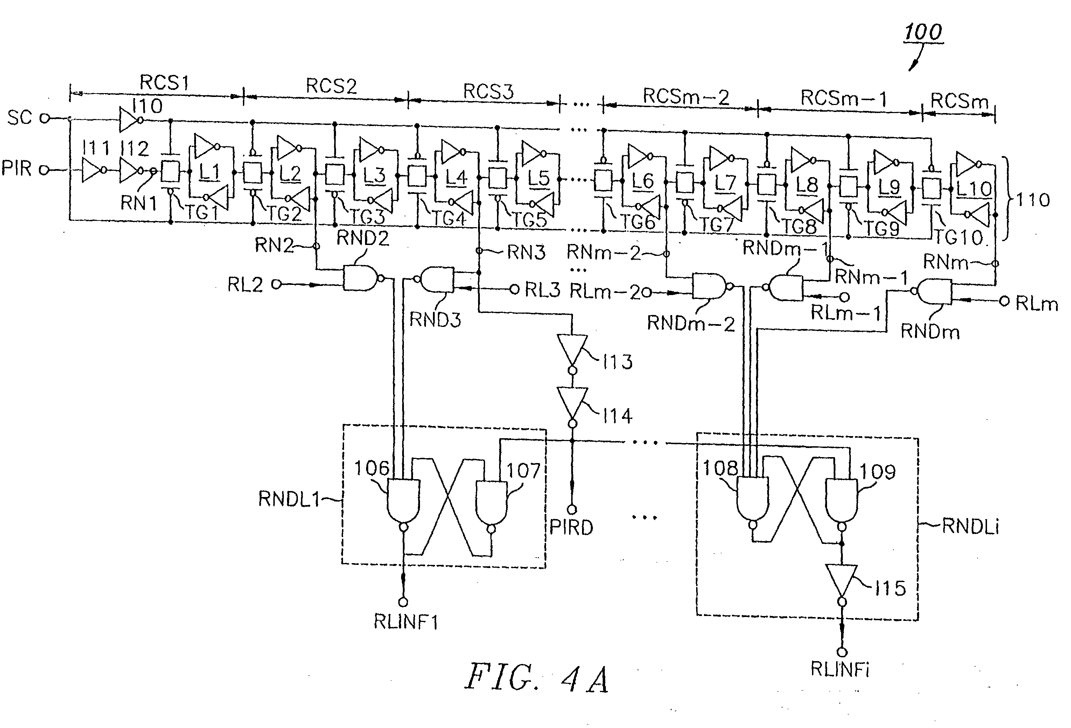

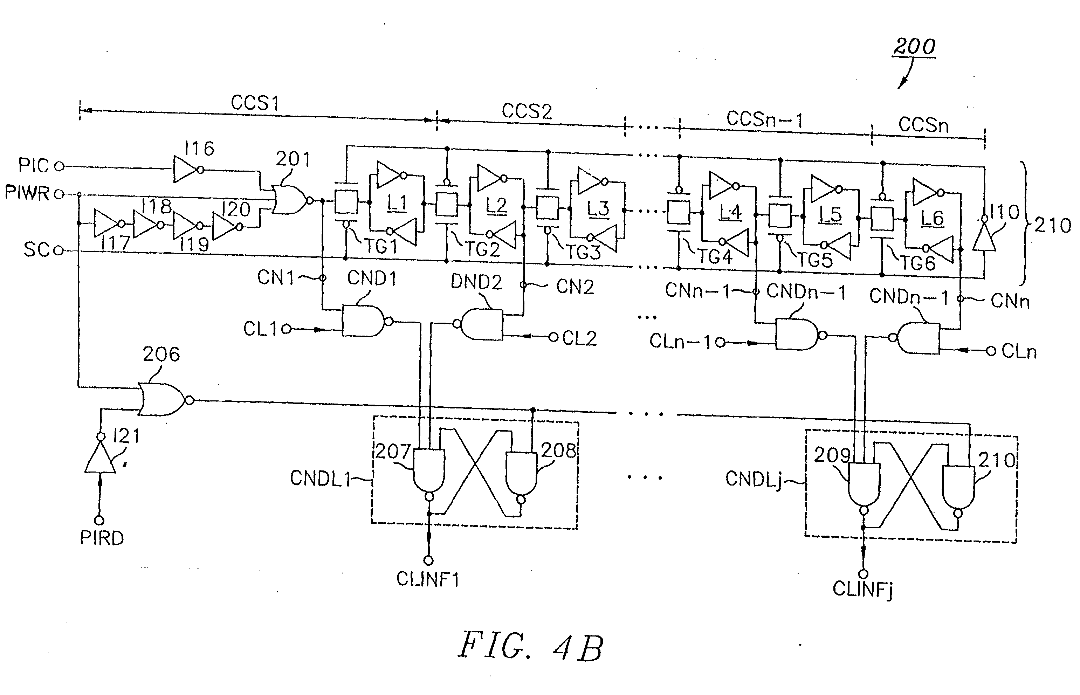

Figures 4A and 4B are examples of the detailed circuit configurations of the /RAS signal processor 100 and the /CAS signal processor 200 that are block-marked respectively in Figure 3. As shown in Figure 4A, the /RAS signal processor 100 is comprised of a shift register 110 having m clock stages RCS1-RCSm, m-1 NAND gates RND2-RNDm each receiving the row address signals RL2-RLm and the voltage at nodes RN2-RNm respectively located in all the clock stages except the first clock stage, inverters I13, I14 connected in series for supplying the data output margin signal PIRD that had been extracted from a node of a clock stage (in the case of Figure 4A, a node RN3 in the third clock stage RCS3) to the /CAS signal processor 200, NAND gates 106 and 108 each receiving signals output from two adjacent NAND gates among the NAND gates RND2-RNDm, other NAND gates 107 and 109 each receiving the data output margin signal PIRD, and i latch circuits RNDL1-RNDLi for generating i /RAS latency signals RLINF1-RLINFi.

Of the latch circuits RNDL1-RNDLi, the respective latch circuits connected to the clock stages positioned before (or left hand side of) a clock stage from which the data output margin signal PIRD is extracted, are coupled to the output signals of the NAND gates receiving the signals output from the adjacent two clock stages among the clock stages RCS2-RCSm, and the rest of the latch circuits positioned after (or right hand side of) a clock stage from which the data output margin signal PIRD is extracted are coupled to the NAND gates receiving the signals output from consecutive three clock stages. If the data output margin signal PIRD is extracted from a node RN1 of the first clock stage RCS1 instead of the node RN3 of the third clock stage RCS3, all the latch circuits RNDL1-RNDLi receive the outputs of the consecutive three NAND gates RND2/RND3/RND4; RND5/RND6/RND7;...; and RNDm-2/RNDm-1/RNDm, respectively.

The first clock stage RCS1 is comprised of a transfer *gate* TG1 and a latch L1 connected in series and receives the /RAS master clock PIR via inverters I11 and I12 connected in series. Of the transfer gates TG1-TG10 included in the respective stages, p-type transfer gates TG1, TG3, TG5, TG7, TG9 and n-type transfer gates TG2, TG4, TG6, TG8, TG10 are alternatively arranged and are all controlled according to the system clock SC. Accordingly, when the system clock SC goes to "high" state, n-type transfer gates TG2, TG4, TG6, TG8, TG10 are all turned on. According to the embodiment of Figure 4A, 2 bits of the output data are further generated even after the /RAS signal has entered the precharge cycle because the data output margin signal PIRD is extracted from the node RN3 of the third clock stage RCS3. However, the extracting position of the data output margin signal PIRD can be changed according to how many bits of the output data should be generated even during the /RAS precharge cycle. A relationship between an extracting position of the data output margin signal PIRD and the number of the output data bits desired to be generated during the /RAS precharge cycle will be explained in detail herebelow.

Referring to Figure 4B, the /CAS signal processor 200 has a shift register 210 composed of n clock stages CCS1-CCSn as in the case of a circuit configuration of the /RAS signal processor 100 illustrated in Figure 4A, as well as n NAND gates CND1-CNDn each receiving the signals at nodes CN1-CNn of the respective clock stages CCS1-CCSn and column address combination signals CL1-CLn. Of the NAND gates CND1-CNDn, the signals being output from two adjacent clock stages are input to NAND gates 207 and 209, respectively. NAND gates 208 and 210 each receiving the output of a NOR gate 206 for receiving the data output margin signal PIRD and a write master clock PIWR to notify the state of the data output margin signal PIRD, together with the NAND gates 207 and 209, constitute j latch circuits CNDL1-CNDLj for generating j /CAS latency signals CLINF1-CLINFj.

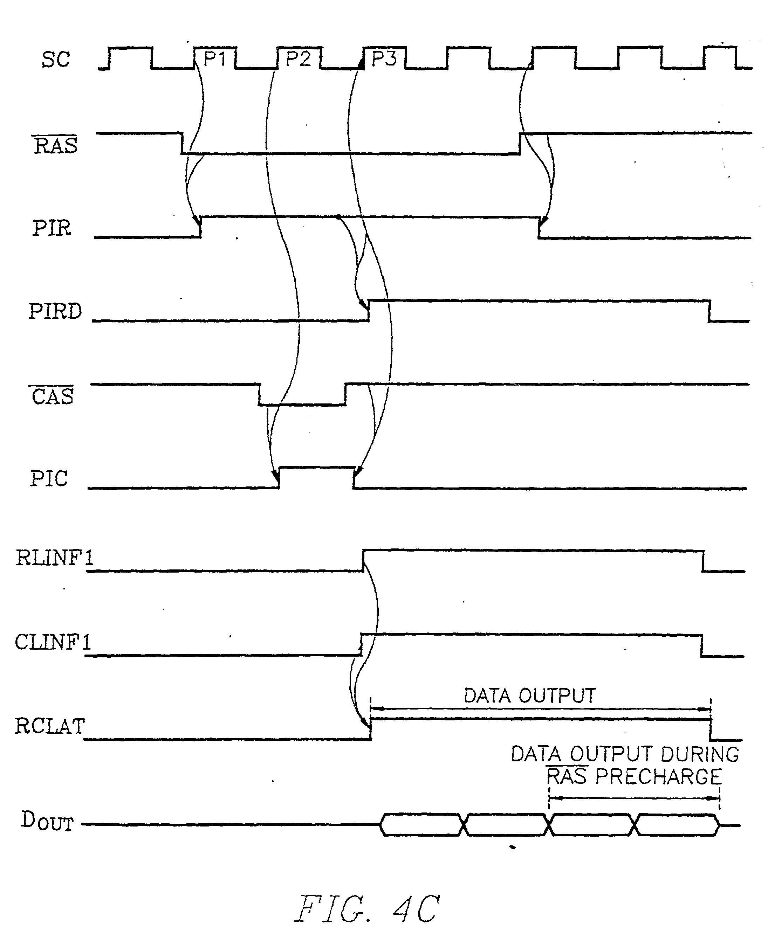

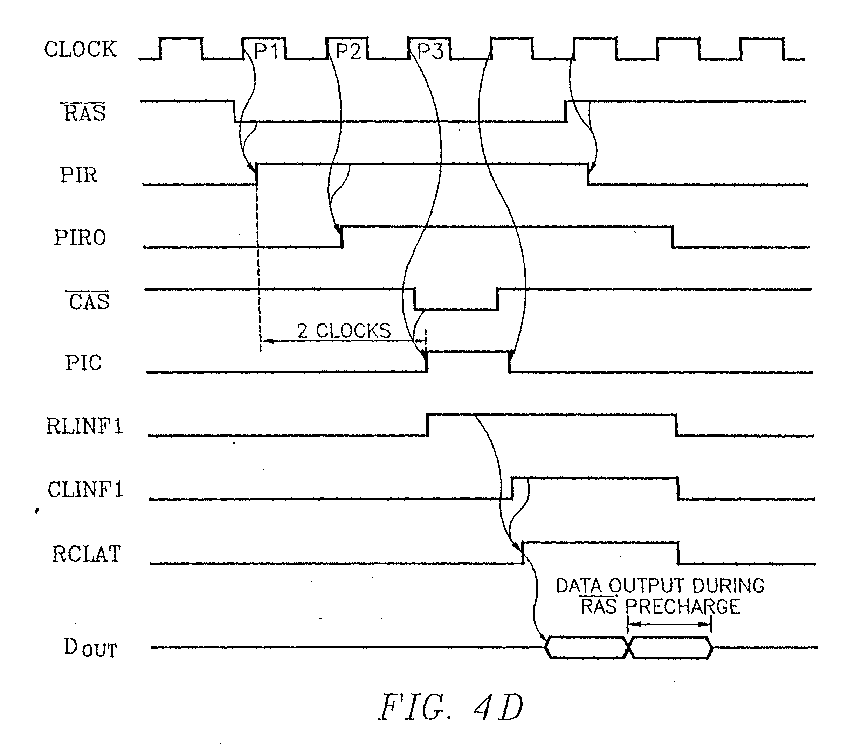

Figure 4C illustrates an operation timing of the case where the data output margin signal PIRD is extracted from the node RN3 as shown in Figure 4. Further, Figure 4D shows an operation timing of the case where the data output margin signal PIRD is extracted from a node RN2.

Referring to Figure 4C, after the /RAS signal has entered into an active cycle in "low" state, the /RAS master clock PIR is enabled to "high" state in synchronism with a rising edge of the system clock SC. In a similar manner, after the /CAS signal has entered into an active cycle in "low" state, a /CAS master clock PIC is enabled to "high" state in synchronism with the rising edge of the system clock SC. As shown in Figure 4A, the /RAS master clock PIR supplied to the clock stage RCS1 is transferred to the node RN3 at a rising edge of the third pulse of the system clock SC. It should be noted that an initial value of each clock stage of shift registers 110 and 210 respectively illustrated in Figures 4A and 4B is in "low" state and that only the row address signal RL3 among the row address combination signals RL2-RLm is in "high" state. Similarly, only the signal CL2 among the column address combination signals CL1-CLn is in "high" state. A detailed description on the setting of the row address combination signals has been omitted since it is a well known technology in the field. It is noted from the foregoing that some of the row and column address combination signals are set to "high" state initially and the signal set to "high" state initially is determined according to how many pulses of the system clock SC should be generated after the activation of the /RAS signal or the /CAS signal. That is, as shown in the timing diagram, output data is generated through a data output buffer 400 illustrated in Figure 3 at a rising edge of a pulse P3 of the system clock SC generated after the /RAS signal is activated when only the signal RL3 among row address combination signals RL2-RLm shown in Figure 4A is supplied to the NAND gate RND3 in "high" state. Output data is generated through the data output buffer 400 illustrated in Figure 3 at the rising edge of the pulse P3 of the system clock SC after the /CAS signal is activated when only the signal CL2 among column address combination signals CL1-CLn shown in Figure 4B is supplied to the NAND gate CND2 in "high" state.

The outputs of the NAND gates RND2, RND4-RNDm except the NAND gate RND3 are all in "high" state since the potential at the node RN3, an output of the clock stage RCS3, is in "high" state, the row address combination signal RL3 is in "high" state, and all the remaining row address combination signals RL2, RL4-RLm are in "low" state. On the other hand, the data output margin signal PIRD being generated through the inverters I13 and I14 connected in series from the node RN3 has an active cycle in "high" state that had been delayed by three pulses of the system clock SC compared to an active cycle in "low" state of the /RAS signal. This is because the data output margin signal PIRD is extracted from the third clock stage RCS3 of a shift register 110. Accordingly, when the data output margin signal PIRD is in "high" state active cycle, the NAND gate 106 receives the "low" state signal supplied from the NAND gate RND3 and therefore, only the /RAS latency signal RLINF1 which is an output of the latch circuit RNDL1 is generated in "high" state.

As shown in Figure 3, the /RAS latency signal RLINF1 in "high" state is supplied to the latency combination circuit 300 and the data output margin signal PIRD is supplied to the /CAS signal processor 200. In the /CAS signal processor 200 of Figure 4B, the potential at the node CN2 of the second clock stage CCS2 goes to "high" state at the rising edge of the pulse P3 of the system clock SC that appears first after the /CAS master clock PIC had been activated to "high" state. Also, since only the signal CL2 among the column address combination signals CL1-CLn is in "high" state in accordance with the previously mentioned conditions, only an output of the NAND gate CND2 among the NAND gates CND1-CNDn is generated in "low" state. Moreover, the data output margin signal PIRD is reversed and then, input into a NOR gate 206 along with a write master clock PIWR which is disabled in "low" state during a read operation. An output of the NOR gate 206 is input to NAND gates 208 and 210 of the latch circuits CNDL1-CNDLj. Therefore, similarly to Figure 4A, the latch circuits CNDL1-CNDLj generate the /CAS latency signals CLINF1-CLINFj in response to outputs of the NAND gates CND1-CNDn. Accordingly, only the /CAS latency signal CLINF1 is output in "high" state while the data output margin signal PIRD is in a "high" state active cycle. The /CAS latency signal CLINF1 is supplied along with the /RAS latency signal RLINF1 to the latency combination circuit 300 of Figure 3. In the end, as shown in Figure 3, only one among the /RAS latency signals RLINF1-RLINFi that are input into the latency combination circuit 300 changes to "high" state and only one among /CAS latency signals CLINF1-CLINFj turns to "high" state. Accordingly, the latency signal RCLAT which is an output of the latency combination circuit 300 is generated in "high" state before being supplied to the data output buffer 400. As shown in the timing diagram, the data that had been detected from the memory cell through the data output buffer 400 is output since the latency signal RCLAT remains in "high" state while the data output margin signal PIRD is maintained in "high" state. It should be particularly noted that 2 bits of the output data are generated even after the /RAS signal enters into the precharge cycle in "high" state. In the conventional memory devices, however, data cannot be output during the /RAS signal being in the precharge cycle.

Figure 4D, unlike the diagram of Figure 4A, illustrates a read timing of the case where the data output margin signal PIRD is extracted from the node RN2 of the second clock stage RCS2. This is to show that the number of data bits to be output during the /RAS precharge cycle can be adjusted freely according to an extracting position of the data output margin signal PIRD in case that the embodiments of the present invention are applied in a memory device. As can be known through the timing state, the data output margin signal PIRD is synchronized with the rising edge of the pulse P2 of the system clock SC generated after /RAS signal had been activated and then, is activated to "high" state. Also, when compared to the point of the /CAS activation shown in Figure 4C, the /CAS activation shown in Figure 4C is delayed by one cycle of the system clock SC. Therefore, it becomes apparent that the /CAS latency signal CLINF1 is input to the latency combination circuit 300 of Figure 3 after being delayed by one system clock cycle when compared to the /RAS latency signal RLINF1. Accordingly, the latency signal RCLAT for controlling the data output buffer 400 changes to "high" state when the /RAS and /CAS latency signals RLINF1 and CLINF1 are both enabled to "high" state thus enabling the data output buffer 400 to output the data. Furthermore, since the activation period of the data output margin signal PIRD is shortened by one system clock cycle in respect to the case of Figure 4C, the number of output data bits that is secured after the /RAS signal had been precharged becomes one. As shown in Figures 4C and 4D, the number of the output data generated after the /RAS signal had been precharged according to an extracting position of the data output margin signal PIRD can be extended or shortened freely before a next /RAS cycle begins; that is, during a time span excluding the time required for equalizing and precharging the input/output lines.

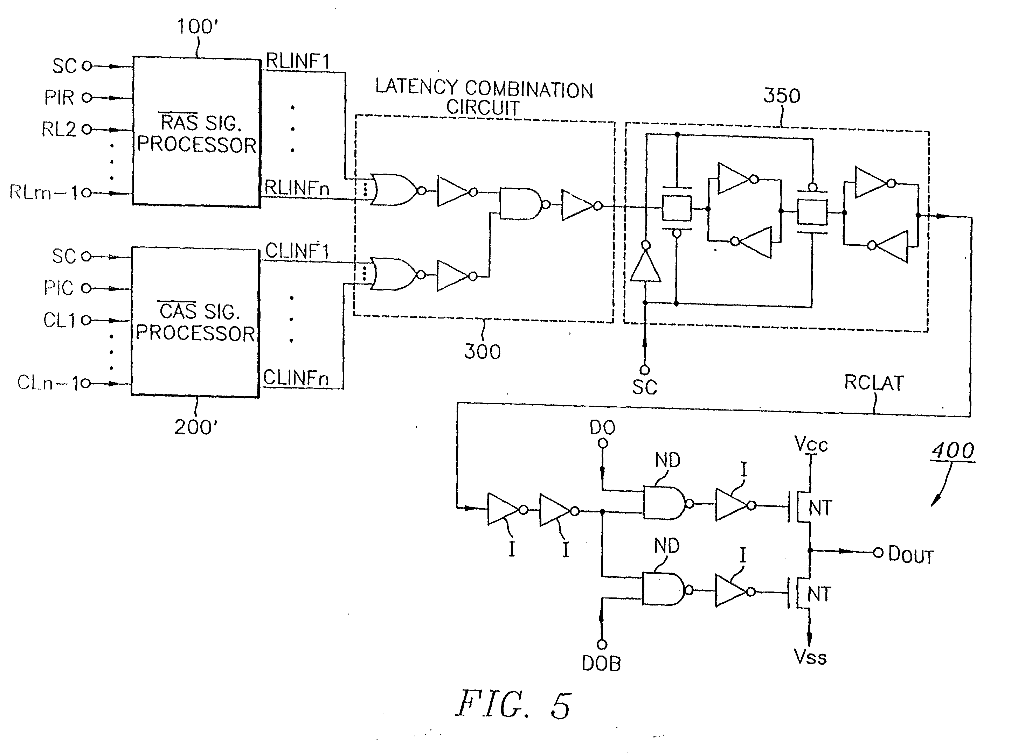

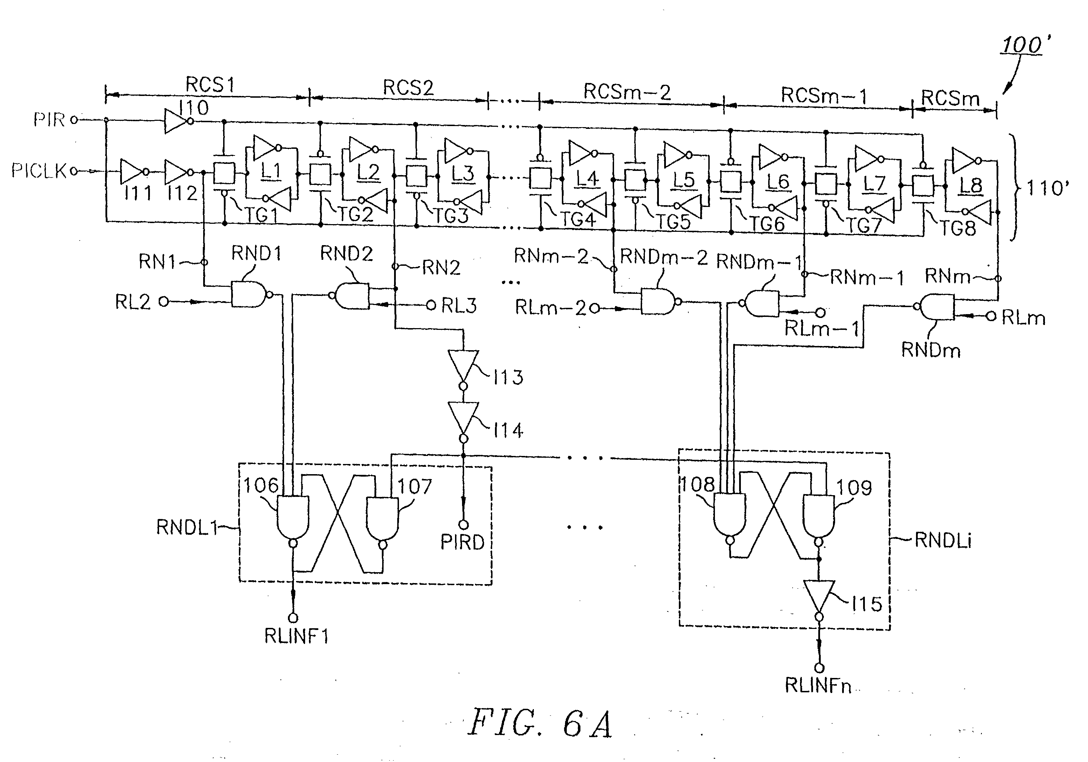

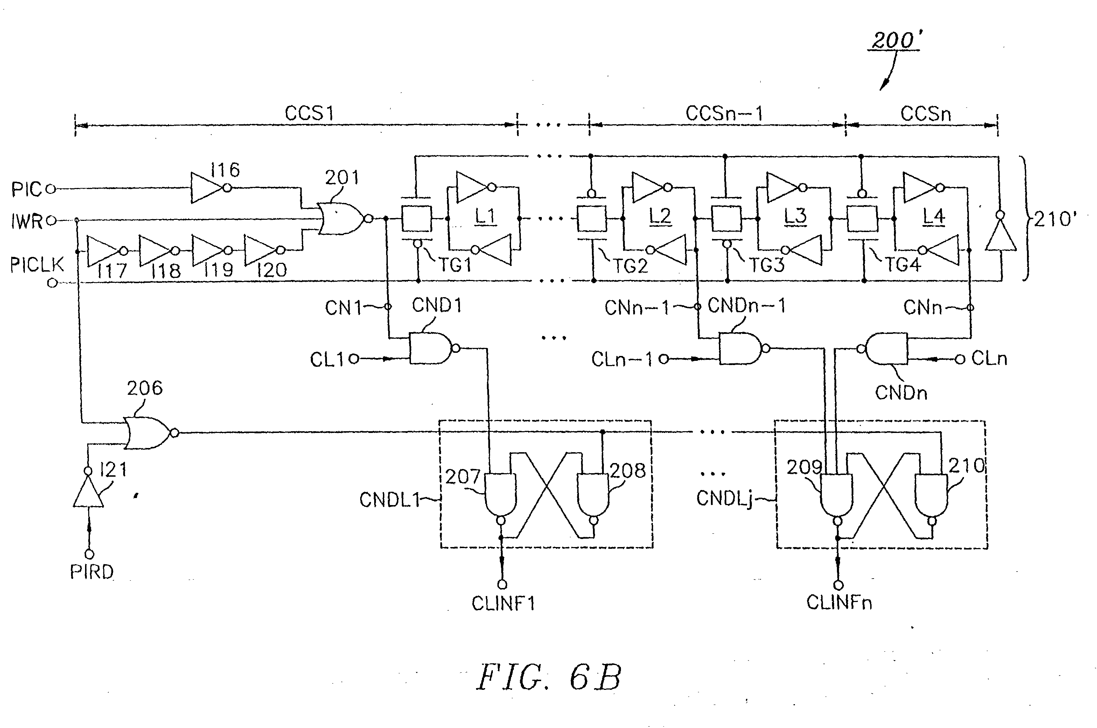

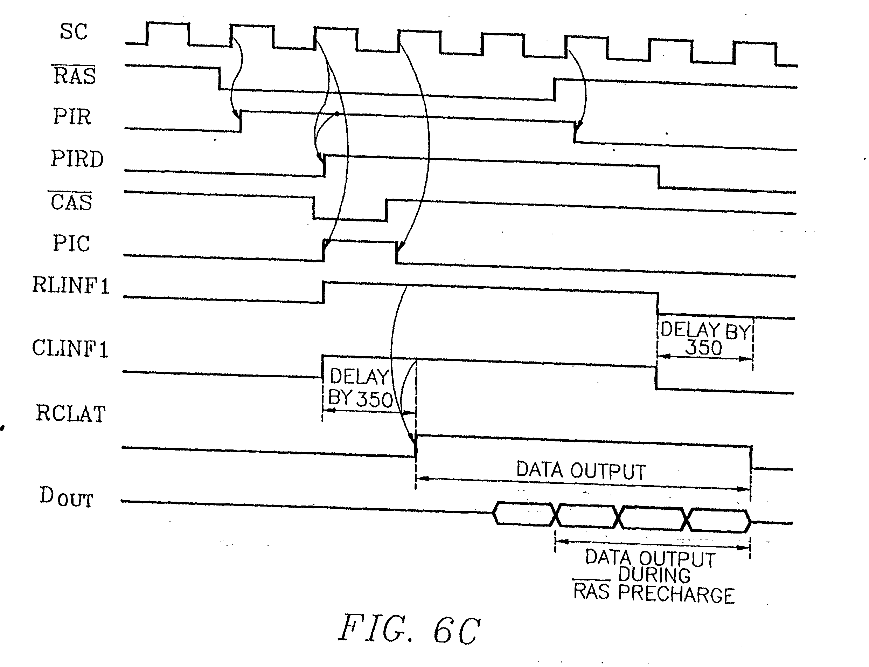

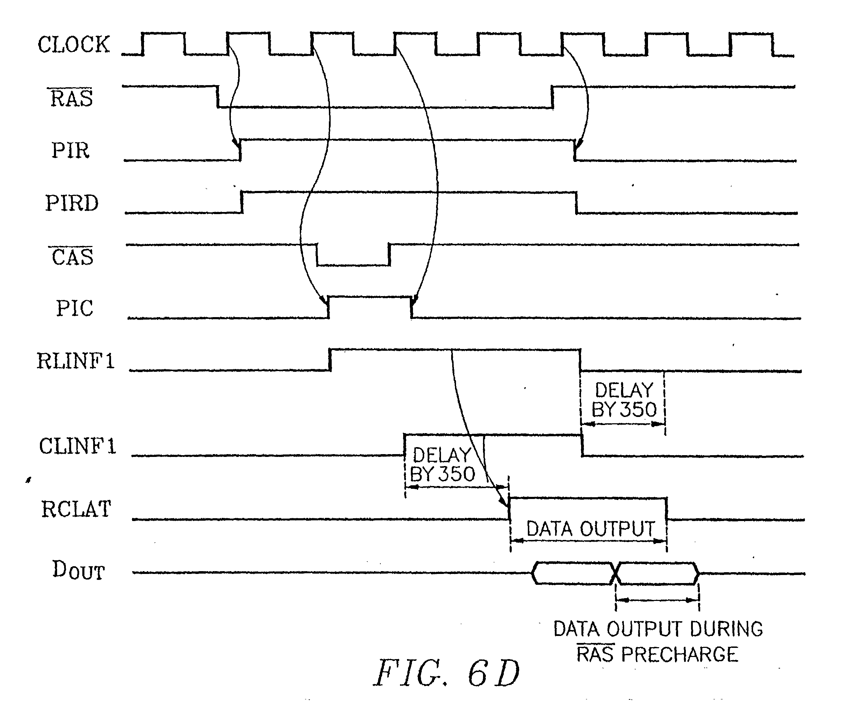

Referring to Figure 5 showing another embodiment of the present invention, a /RAS signal processor 100' and a /CAS signal processor 200' respectively include the shift registers each having the clock stages being the same in structure as that of the shift resistors 110 and 210 of Figures 4A and 4B, but the number of the clock stages included in the shift registers each is one less in number than that of the shift resistors 110 and 210 of Figures 4A and 4B. Further, a shift stage 350 is connected to an output of the latency combination circuit 300 of Figure 3 so as to generate the latency signal RCLAT through the shift stage 350. Other configurations are the same as the embodiment of the present invention previously described. The detailed circuit diagram of the /RAS signal processing and the /CAS signal processor 100', 200' of Figure 5 is illustrated respectively in Figures 6A and 6B. The timing diagram of Figure 6C shows a data reading operation of the case where the data output margin signal PIRD is extracted from a node RN2 of the second stage RCS2 of a shift register of the /RAS signal processor 100' shown in Figure 6A. The timing diagram of Figure 6D shows a data reading operation of the case where the data output margin signal PIRD is extracted from a node RN1 of the first stage RCS1. An operation according to another embodiment of the present invention shown in Figure 5 and Figures 6A-6D overlaps with the explanation of the embodiment of the present invention given in Figure 3 and Figures 4A-4D and therefore is not described further.

In the embodiments of the present invention previously described, the latency signal RCLAT was described as a signal having the information on the /RAS signal and the /CAS signal. It can be generated using either the /RAS signal or the /CAS signal. For example, in case of using the /RAS signal only in the circuit of Figure 3, one among the /RAS latency signals RLINF1-RLINFi is changed to an active state by using the /RAS signal processor 100 only, and supplied to the latency combination circuit 300, without configuring the /CAS signal processor 200 for generating the /CAS latency signal.

The above-described examples of memory devices of the present invention are capable of controlling output data in synchronism with the system clock SC supplied from an external source by using the information on the /RAS and/or the /CAS address strobe signals. Therefore, embodiments of the present invention may allow a memory device that uses a highfrequency clock being supplied from the CPU to effectively control the data output for the faster operation speed. Moreover, embodiments of the present invention may be capable of generating normal output data even after the /RAS precharge at least until the beginning of the next /RAS cycle. Therefore, embodiments of the present invention can generate more output data than the number of output data that can be generated by conventional memory devices during one /RAS cycle.

## Claims

1. A data output control method in a synchronous semiconductor memory device having a data output buffer (400) for outputting data responsive to a data output control signal (RCLAT),
**characterized by**
generating a row address strobe latency signal (RLINF1 to RLINFi) for controlling the output margin of data responsive to the activation of the row address strobe signal;
generating a column address strobe latency signal (CLINF1 to CLINFi) for controlling the output margin of data responsive to the activation of the column address strobe signal;
freely adjusting the number of data bits responsive to the generated latency signals (RLINF1 to RLINFi; CLINF1 to CLINFi), generating a data output buffer control signal (RCLAT) synchronized with the system clock for controlling the data output margin, and controlling the data output buffer (400) by control of the generated data output buffer control signal (RCLAT) so that data is outputted from the memory device even during a memory precharge period (RAS PRECHARGE).

2. A synchronous semiconductor memory device (10) having a data output buffer (400) for outputting data responsive to a data output control signal (RCLAT),
**characterized by**
means (100) for generating a row address strobe latency signal (RLINF1 to RLINFi) for controlling the output margin of data responsive to the activation of the row address strobe signal;
means (200) for generating a column address strobe latency signal (CLINF1 to CLINFi) for controlling the output margin of data responsive to the activation of the column address strobe signal;
means (300) for freely adjusting the number of data bits responsive to the generated latency signals (RLINF1 to RLINFi; CLINF1 to CLINFi), means for generating a data output buffer control signal (RCLAT) synchronized with the system clock for controlling the data output margin, and means for controlling the data output buffer (400) by control of the generated data output buffer control signal (RCLAT) so that data is outputted from the memory device even during a memory precharge periods (RAS PRECHARGE).

## Patentansprüche

1. Datenausgabe-Steuerverfahren in einer synchronen Halbleiterspeichervorrichtung mit einem Datenausgabepuffer (400) zum Ausgeben von Daten ansprechend auf ein Datenausgabe-Steuersignal (RCLAT),
**gekennzeichnet durch**
Erzeugen eines Zeilenadresshinweis-Latenzsignals (RLINF1 bis RLINFi) zum Steuern der Ausgabespanne von Daten ansprechend auf die Aktivierung des Zeilenadress-Hinweissignals;
Erzeugen eines Spaltenadresshinweis-Latenzsignals (CLINF1 bis CLINFi) zum Steuern der Ausgabespanne von Daten ansprechend auf die Aktivierung des Spaltenadress-Hinweissignals;
Freies Einstellen der Anzahl der Datenbits ansprechend auf die erzeugten Latenzsignale (RLINF1 bis RLINFi; CLINF1 bis CLINFi);
Erzeugen eines Datenausgabepuffer-Steuersignals (RCLAT), welches mit dem Taktsignal zum Steuern der Datenausgabespanne synchronisiert wird; und
Steuern des Datenausgabepuffers (400) **durch** Steuern des erzeugten Datenausgabepuffer-Steuersignals (RCLAT), so dass Daten von der Speichervorrichtung auch während einer Speichervorladeperiode (RAS PRECHARGE) ausgegeben werden.

2. Synchrone Halbleiterspeichervorrichtung (10) mit einem Datenausgabepuffer (400) zum Ausgeben von Daten ansprechend auf das Datenausgabe-Steuersignal (RCLAT),
**gekennzeichnet durch**
Mittel (100) zum Erzeugen eines Zeilenadresshinweis-Latenzsignals (RLINF1 bis RLINFi) zum Steuern der Ausgabespanne von Daten ansprechend auf die Aktivierung des Zeilenadress-Hinweissignals;
Mittel (200) zum Erzeugen eines Spaltenadresshinweis-Latenzsignals (CLINF1 bis CLINFi) zum Steuern der Ausgabespanne von Daten ansprechend auf die Aktivierung des Spaltenadress-Hinweissignals;
Mittel (300) zum freien Einstellen der Anzahl der Datenbits ansprechend auf die erzeugten Latenzsignale (RLINF1 bis RLINFi; CLINF1 bis CLINFi);
Mittel zum Erzeugen eines Datenausgabepuffer-Steuersignals (RCLAT), welches mit dem Taktsignal zum Steuern der Datenausgabespanne synchronisiert wird; und
Mittel zum Steuern des Datenausgabepuffers (400) **durch** Steuern des erzeugten Datenausgabepuffer-Steuersignals (RCLAT), so dass Daten von der Speichervorrichtung auch während einer Speichervorladeperiode (RAS PRECHARGE) ausgegeben werden.

## Revendications

1. Procédé de commande de sortie de données dans un dispositif de mémoire à semiconducteurs synchrone ayant un tampon de sortie de données (400) pour délivrer en sortie des données en réponse à un signal de commande de sortie de données (RCLAT),
**caractérisé par**
la génération d'un signal de latence (RLINP1 à RLINFi) d'échantillonnage d'adresse de rangée pour commander la marge de sortie de données en réponse à l'activation du signal d'échantillonnage d'adresse de rangée ;
la génération d'un signal de latence (CLINF1 à CLINFi) d'échantillonnage d'adresse de colonne pour commander la marge de sortie de données en réponse à l'activation du signal d'échantillonnage d'adresse de colonne ;
l'ajustement libre du nombre de bits de données en réponse aux signaux de latence générés (RLINFI à RLINFi ; CLINFI à CLINFi), la génération d'un signal de commande de tampon de sortie de données (RCLAT) synchronisé avec l'horloge du système pour commander la marge de sortie de données, et la commande du tampon de sortie de données (400) par une commande du signal de commande (RCLAT) de tampon de sortie de données généré afin que des données soient délivrées en sortie du dispositif de mémoire même pendant une période de précharge de mémoire (PRECHARGE DE RAS).

2. Dispositif de mémoire à semiconducteurs synchrone (10) ayant un tampon (400) de sortie de données pour délivrer en sortie des données en réponse à un signal (RCLAT) de commande de sortie de données,
**caractérisé par**
des moyens (100) destinés à générer un signal de latence (RLINFI à RLINFi) d'échantillonnage d'adresses de données pour commander la marge de sortie de données en réponse à l'activation du signal d'échantillonnage d'adresse de rangée ;
des moyens (200) destinés à générer un signal de latence (CLINF1 à CLINFi) d'échantillonnage d'adresse de colonne pour commander la marge de sortie de données en réponse à l'activation du signal d'échantillonnage d'adresse de colonne ;
des moyens (300) destinés à régler librement le nombre de bits de données en réponse aux signaux de latence générés (RLINF1 à RLINFi ; CLINFI à CLINFi), des moyens destinés à générer un signal de commande (RCLAT) de tampon de sortie de données synchronisé avec l'horloge du système pour commander la marge de sortie de données, et des moyens destinés à commander le tampon de sortie de données (400) par une commande du signal (RCLAT) de commande de tampon de sortie de données généré afin que des données soient délivrées en sortie du dispositif de mémoire même pendant une période de précharge de mémoire (précharge RAS).
